# EUROPEAN PATENT APPLICATION

(11) **EP 4 838 300 A1**
(43) Date of publication of application: **11.11.2026**
(21) Application number: 26169422.8
(22) Date of filing: 31.03.2026
(51) Int. Cl.: G03F 1/62, B05D 1/00, B82Y 30/00, B82Y 40/00, C23C 14/00, C23C 14/02, C23C 14/08, C23C 14/14, C23C 14/20, C23C 14/58, C23C 16/56

(54) **A PLANARIZED STRUCTURE**

(30) Priority: 15.04.2025 FI 20255342
(71) Applicant: Canatu Finland Oy, 01720 Vantaa (FI)
(72) Inventor: CHIAPPE, Daniele, 01720 Vantaa (FI); MIKLADAL, Bjørn, 01720 Vantaa (FI); SOLIMAN, Ahmed, 01720 Vantaa (FI)
(74) Representative: Papula Oy

(57) **Abstract**

A method for producing a planarized structure comprising a film of carbon nanostructures on a metal-containing or metalloid-containing coating layer is disclosed. The method comprises: - providing a pre-film of carbon nanostructures, - forming a polymer-based material on the pre-film of carbon nanostructures to form a planarization layer on the pre-film of carbon nanostructures,
- forming a metal-containing or metalloid-containing material on the planarization layer to form a planarized metal-containing or metalloid-containing coating layer,
- providing a film of carbon nanostructures on the planarized metal-containing or metalloid-containing coating layer to form a pre-structure, - subjecting the formed pre-structure to a vapor phase densification treatment, and - removing the pre-film of carbon nanostructures and the planarization layer from the pre-structure to produce the planarized structure. Further is disclosed the use of the planarized structure obtainable by the method.

## Description

### TECHNICAL FIELD

The present disclosure relates to a method for producing a planarized structure comprising a film of carbon nanostructures on a metal-containing or metalloid-containing coating layer. The present disclosure further relates to the use of the obtained planarized structure.

### BACKGROUND

Extreme ultraviolet lithography (EUV or EUVL) is an optical lithography technology using a range of extreme ultraviolet wavelengths. EUV pellicles are used to protect a photomask from defects, enhance precision, shorten processing, and increase production efficiency on a wafer. However, defects in printing remain a key constraint to EUV lithography uptake. Further, optical filters are components designed to selectively transmit or block specific wavelengths of light. These filters play a role in applications such as spectroscopy, telecommunications, biomedical imaging, and photography. The material and coating technologies used determine their performance, including spectral range, durability, and thermal resistance. Despite their advantages, the performance of optical filters can be constrained by challenges such as durability under high-power laser applications, thermal degradation, and manufacturing tolerances. Surface defects, coating inconsistencies, or environmental factors like humidity can introduce scattering or absorption losses, reducing filter efficiency and lifespan. Thus, sophisticated filters like the EUV pellicles or optical filters are needed.

### SUMMARY

A method for producing a planarized structure comprising a film of carbon nanostructures on a metal-containing or metalloid-containing coating layer is disclosed. The method comprises:
- providing a pre-film of carbon nanostructures,
- forming a polymer-based material on the pre-film of carbon nanostructures by a first vapor phase deposition technique to form a planarization layer on the pre-film of carbon nanostructures,
- forming a metal-containing or metalloid-containing material on the planarization layer by a second vapor phase deposition technique to form a planarized metal-containing or metalloid-containing coating layer on the planarization layer,
- providing a film of carbon nanostructures on the planarized metal-containing or metalloid-containing coating layer to form a pre-structure,
- subjecting the formed pre-structure to a vapor phase densification treatment, and
- removing the pre-film of carbon nanostructures and the planarization layer from the pre-structure by a dry etching technique to produce the planarized structure.

Further is disclosed the use of a planarized structure obtainable by the method as disclosed in the current specification as an optical filter, a debris filter, a pellicle, a membrane filter, an electron blocking window, or any combination of at least two of these.

### BRIEF DESCRIPTION OF THE DRAWINGS

The accompanying drawings, which are included to provide a further understanding of the embodiments and constitute a part of this specification, illustrate embodiments and together with the description help to explain the principles of the invention. In the drawings:
Fig. 1 present one embodiment for producing the planarized structure,
FIG. 2a and Fig. 2b presents the results from example 1, and
Fig. 3 presents the results from example 2.

### DETAILED DESCRIPTION

The present disclosure relates to a method for producing a planarized structure comprising a film of carbon nanostructures on a metal-containing or metalloid-containing coating layer, wherein the method comprises:
- providing a pre-film of carbon nanostructures,
- forming a polymer-based material on the pre-film of carbon nanostructures by a first vapor phase deposition technique to form a planarization layer on the pre-film of carbon nanostructures,
- forming a metal-containing or metalloid-containing material on the planarization layer by a second vapor phase deposition technique to form a planarized metal-containing or metalloid-containing coating layer on the planarization layer,
- providing a film of carbon nanostructures on the planarized metal-containing or metalloid-containing coating layer to form a pre-structure,
- subjecting the formed pre-structure to a vapor phase densification treatment, and
- removing the pre-film of carbon nanostructures and the planarization layer from the pre-structure by a dry etching technique to produce the planarized structure.

The present disclosure further relates to the use of the planarized structure obtainable by the method as disclosed in the current specification as an optical filter, a debris filter, a pellicle, a membrane filter, an electron blocking window, or any combination of at least two of these.

In one embodiment, the planarized structure is used as an extreme ultraviolet lithography pellicle.

In one embodiment, the planarized structure consists of a film of carbon nanostructures on a metal-containing or metalloid-containing coating layer.

In one embodiment, the pre-film of carbon nanostructures is a free-standing pre-film of carbon nanostructures or a mesh-supported pre-film of carbon nanostructures.

The term "mesh" may in this specification refer to an interlaced structure. A mesh may be taken as a support made of interlaced strands of e.g. metal.

Carbon nanostructures are used to form the (pre-)film. The expression "nanostructures" should be understood in this specification, unless otherwise stated, as structures with one or more characteristic dimensions in nanometer scale, i.e. typically ranging from 1 to 100 nanometers. The dimensions of the nanostructures, in two perpendicular directions, may be in significantly different magnitudes of order. For example, a nanostructure may have a length which is ten, hundred, thousand, or even hundred thousand, times higher than its thickness or width.

In a (pre-)film of carbon nanostructures, a great number of said carbon nanostructures are interconnected with each other to form a network of interconnected molecules. As considered at a macroscopic scale, such a network forms a solid, monolithic material in which the individual molecular structures are disoriented or non-oriented, i.e. are oriented substantially randomly, or oriented. Various types of carbon nanostructure networks can be produced in the form of thin transparent layers. In a film of carbon nanostructures collected from a forest, the carbon nanostructures typically retain an aligned or semi-aligned configuration, where individual nanostructures are vertically oriented. When processed into a film, these structures may exhibit partial interconnections due to van der Waals forces or physical entanglement, forming a network while preserving some of the alignment characteristic of the original forest.

In one embodiment, the carbon nanostructures are carbon nanotubes (CNT), carbon nanobuds (CNB), carbon nanoribbons, carbon nanofibers, or any combination or mixture thereof. In one embodiment, the carbon nanostructures are carbon nanotubes, carbon nanobuds, or a combination or mixture of these. The carbon nanobuds, or the carbon nanobud molecules as they also may be called, have fullerene or fullerene-like molecules covalently bonded to the side of a tubular carbon molecule. Carbon nanotubes and carbon nanobuds as such have the added utility of being highly transparent in the X-ray and visible light wavelengths. In addition, they have robust mechanical properties and high chemical inertness.

Various procedures exist in the art that may be used for forming the (pre-)film of carbon nanostructures. Different manners may be used to synthesize the carbon nanostructures and/or to deposit the same to form a film. In the case of e.g. carbon nanotubes or carbon nanobud molecules, deposition may be carried out, for example, by using the commonly known methods of filtration from gas phase or from liquid, extracting from a solution, deposition in a force field, or deposition from a solution using spray coating or spin drying. The carbon nanobud molecules can be synthesized, for example, using the method disclosed in WO 2007/057501, and deposited on a substrate, for example, directly from the aerosol flow, e.g. by assistance of e.g. electrophoresis or thermophoresis, or by a method described in Nasibulin et al: "Multifunctional Free-Standing Single-Walled 20 Carbon Nanotube Films", ACS NANO, vol. 5, no. 4, 3214-3221, 2011. Functionalization of carbon nanostructures may be considered as the generation of functional groups on the surfaces of the carbon nanostructures. Functionalization of carbon nanostructures may be done either by physisorption or by covalent attachments. Functionalization of the carbon nanostructures has the added utility of making them more reactive, increasing their solubility, or allowing various chemical modifications, such as ion adsorption, metal deposition, or grafting reactions.

A (pre-)film of carbon nanostructures may be formed by synthesizing carbon nanostructures e.g. in a gas phase from where they are collected or deposited. The carbon nanostructures may be collected or deposited to form a film of carbon nanostructures with no specific orientation, or they may be aligned in a particular direction.

The (pre-)film of carbon nanostructures may have the area size of 0.1 - 1000 cm², or 1 - 500 cm², or 5 - 350 cm², or 10 - 200 cm², or 50 - 150 cm².

The thickness of the (pre-)film of carbon nanostructures may be 1 - 8000 nm, or 5 - 7500 nm, or 15 - 7000 nm, or 20 - 5000 nm, or 50 - 2500 nm, or 100 - 1000 nm, or 200 - 600 nm. In one embodiment, the thickness of the (pre-)film of carbon nanostructures is 1 - 600 nm, or 15 - 500 nm, or 20 - 400 nm, or 50 - 300 nm, or 100 - 200 nm, or 75 - 100 nm. In one embodiment, the thickness of the (pre-)film of carbon nanostructures is 100 - 8000 nm, or 200 - 7000 nm, or 300 - 5000 nm, or 400 - 2500 nm, or 500 - 1000 nm. The thickness of the (pre-)film of carbon nanostructures may be measured with a contact profilometer, such as atomic force microscopy (AFM), an optical profilometer, an ellipsometry, or a cross-sectional electron microscopy. Forming a (pre-)film of carbon nanostructures has the added utility of one being able to form a thin film. However, the (pre-)film of carbon nanostructures may not be too thin as this would affect its ability to support itself in case of being a free-standing (pre-)film of carbon nanostructures.

The pre-film of carbon nanostructures may thus be a free-standing pre-film of carbon nanostructures. The free-standing pre-film may be one that can exist on its own without the need for a supporting substrate across its entire area. The free-standing pre-film of carbon nanostructures can be self-supporting, meaning that the film has sufficient mechanical integrity and strength to maintain its structure independently. A free-standing (pre-)film may typically be directly formed as an independent entity but also a substrate-grown film may be produced so as to be free-standing after the substrate is removed. A defining characteristic of any free-standing film can be its ability to maintain its structure without a supporting substrate. Regardless of whether the free-standing film is formed on a substrate or not, it can be considered free-standing if, after any processing steps, it can exist and function independently, in particular as described above. The free-standing film does not need to be directly supported throughout its whole area since it can maintain its structure without a direct support. It provides, by itself, an intrinsic structural support for maintaining its structure, e.g. its shape. This can be observed under gravity, in absence of supporting forces to the free-standing film. The free-standing (pre-)film(s) as described herein can thus also be understood as self-supporting (pre-)film(s).

The (pre-)film of carbon nanostructures may when needed or desired be attached to a support. Support positions may be located anywhere in the structure to stabilize the (pre-)film of carbon nanostructures where necessary, while the film itself can maintain its structure without requiring support across its entire area, or the free-standing region thereof.

The support may be any type of support suitable to be attached with the free-standing (pre-)film of carbon nanostructures. The support may be formed of glass, metal, plastic, or any combination thereof. The form of the support may vary. The support may have the form of a frame. In one embodiment, the support has the form of a frame, and the (pre-)film or carbon nanostructures is attached to the frame. The frame may support the free-standing (pre-)film of carbon nanostructures at the outer edges thereof such that an unsupported standalone region of the carbon nanostructure film is formed. The support positions may be located anywhere in the structure as long as they provide sufficient support for the carbon nanostructure film. For example, they may be on the sides of the free-standing pre-film of carbon nanostructures, or in areas near corners, or next to each other along the sides. Any wider area that includes a plurality of support points is also meant to be covered by this aspect, for example if the frame has an uninterrupted circular shape wherein the free-standing region lies within the circle. The frame may also have any other prolonged uninterrupted shape. In one embodiment, the frame is shaped as a circle, a square, a triangle, a rectangle, an oval, or a polygon.

A polymer-based material is formed on the pre-film of carbon nanostructures to form a planarization layer. The term "polymer-based material" as used herein may be taken to refer to a material having a polymer content of 50 - 100 weight-%. As examples of the polymer-based material used to form the planarization layer may be mentioned the following: organic polymers such as parylene and polyamide; naphthalene-containing polymers, oxygen-containing polymers such as poly(methyl methacrylate) (PMMA); hydrocarbon-based polymers consisting of carbon and hydrogen such as polystyrene; oligomers such as short-chain polystyrene, and oligoethylene glycol; solvent processable fluoropolymers such as polyvinylidene floride (PVDF; and polyolefins such as polypropylene, polyethylene, and polymethylpentene.

In one embodiment, the polymer-based material is an oxygen-free polymer-based material. Forming the planarization layer of a polymer-based material, such a parylene, has the added utility that the material may not generate oxygen-containing by-products during the upcoming dry etching treatment. Oxygen-containing by-products could potentially attack the formed metal-containing or metalloid-containing coating layer in an adverse manner.

In one embodiment, the polymer-based material is parylene.

The polymer-based material may be parylene. Parylene belongs to the poly-para-xylylene family. This family includes various types of parylene, such as Parylene N, Parylene C, Parylene D, and Parylene HT, which differ based on their chemical modifications. The parylene may be un-substituted parylene (parylene N), chlorinated parylene (parylene C, parylene D), fluorinated parylene (parylene AF-4), alkyl-substituted parylene (parylene M, parylene E), reactive parylene (parylene A, Parylene AM), colored parylene, or crosslinked parylene (parylene X). The colored parylene may be considered as parylene having a chromophore directly attached to the [2.2]paracyclophane base molecule to impart color to parylene. Parylene N has the added utility of containing only carbon and hydrogen, which makes its structure close to the one of carbon nanotubes or carbon nanobuds. Parylene N thus has the added utility of not containing heteroatoms like oxygen, nitrogen, or halogens, which could interfere with carbon nanotube interactions.

The polymer-based material may be formed on the pre-film of carbon nanostructures by a first vapor phase deposition technique. A vapor phase deposition technique may be any generic method where material is deposited from a vapor phase. In one embodiment, the first vapor phase deposition technique is thermal evaporation deposition, molecular layer deposition (MLD), or chemical vapor deposition (CVD). Using a first vapor phase deposition technique for forming the planarization layer has the added utility of being a technique by which one may accurately control the thickness of the formed layer such that a layer thickness down to few tens of nanometers may be formed. Using a first vapor phase deposition technique has the added utility that one may efficiently fill any gaps present between the carbon nanostructures in the pre-film without the need to form a thick layer. Forming a thin planarization layer has the added utility of one being able to carry out the upcoming dry etching technique that may not affect the quality of the metal-containing or metalloid-containing coating layer formed.

In one embodiment, the method comprises forming a planarization layer having a thickness of 1 - 200 nm, or 5 - 180 nm, or 10 - 150 nm, or 20 - 100 nm, or 30 - 80 nm, or 40 - 60 nm. The thickness of the planarization layer may be measured by using e.g. electron microscopy cross-section or X-ray reflectivity.

The planarization layer thus has the added utility of providing a smooth and uniform surface prior to forming a metal-containing or metalloid-containing coating layer thereon. Any unevenness in the surface at this stage would be copied to the metal-containing or metalloid-containing coating layer in an adverse manner, thus affecting the final use of the structure.

Having formed the planarization layer, the metal-containing or metalloid-containing material is formed thereon by a second vapor phase deposition technique to form a planarized metal-containing or metalloid-containing coating layer. The term "metal-containing material" as used herein may be taken to refer to a material containing metal element(s) or metal-containing compound(s). In one embodiment, the metal-containing material has a metal content of 50 - 100 weight-%. Thus, the planarized metal-containing coating layer may contain metal in a total amount of 50 - 100 weight-%.

The term "metalloid-containing material" as used herein may be taken to refer to a material containing metalloid element(s) or metalloid-containing compound(s). In one embodiment, the metalloid-containing material has a metalloid content of 50 - 100 weight-%. Thus, the planarized metalloid-containing coating layer may contain metalloid in a total amount of 50 - 100 weight-%.

In one embodiment, the second vapor phase deposition technique is selected from sputtering deposition, electron-beam physical vapor deposition, thermal evaporation deposition, cathodic arc deposition, pulsed laser deposition, or ion beam-assisted deposition. Sputtering deposition uses a plasma to eject material from a target, which then deposits onto the planarization layer. Electron-beam physical vapor deposition utilizes a high-speed electron beam to vaporize the coating material, which then condenses on the planarization layer. In thermal evaporation deposition material is heated to a high vapor pressure using electrical resistance, allowing it to deposit on the planarization layer. In cathodic arc deposition a high-power electric arc is utilized to vaporize the target material, which then deposits onto the planarization layer. In pulsed laser deposition a high-power laser is utilized to ablate material from the target, creating a vapor that deposits on the planarization layer. Ion beam-assisted deposition combines physical vapor deposition with simultaneous ion bombardment to improve film properties.

Using the second vapor phase deposition technique for forming the metal-containing or metalloid-containing coating layer has the added utility of one being able to form a thin coating layer with a smooth and uniform surface.

In one embodiment, the metal-containing or metalloid-containing coating layer has a thickness of 1 - 300 nm, or 3 - 100 nm, or 5 - 50 nm, or 7 - 30 nm, or 9 - 20 nm, or 10 - 15 nm. The thickness of the metal-containing or metalloid-containing coating layer may be measured with e.g. transmission electron microscopy (TEM) technique, scanning electron microscopy (SEM) technique, or any other relevant technique.

In one embodiment, the metal-containing material is a material based on aluminium, zirconium, tungsten, molybdenum, titanium, yttrium, metal silicide, ruthenium, beryllium, gold, palladium, or niobium. The metal-containing coating layer may be formed of aluminium, zirconium, tungsten, molybdenum, titanium, yttrium, metal silicide, ruthenium, beryllium, gold, palladium, niobium, or any a carbide, an oxide, a nitride, a sulphide, a phosphide, an oxy-nitride, or a boride thereof, or any combination or mixture thereof. The metal-containing coating layer may comprise or consist of aluminium, zirconium, tungsten, molybdenum, titanium, yttrium, metal silicide, ruthenium, beryllium, gold, palladium, niobium, or any a carbide, an oxide, a nitride, a sulphide, a phosphide, an oxy-nitride, or a boride thereof, or any combination or mixture thereof. In one embodiment, the metal-containing material is zirconium boride or molybdenum sulphide.

In one embodiment, the metalloid-containing material is a material based on silicon or boron. The metalloid-containing coating layer may be formed of boron or silicon, or any a carbide, an oxide, a nitride, a sulphide, a phosphide, an oxy-nitride, or a boride thereof, or any combination or mixture thereof. The metalloid-containing coating layer may comprise or consist of silicon or boron, or any a carbide, an oxide, a nitride, a sulphide, a phosphide, an oxy-nitride, or a boride thereof, or any combination or mixture thereof.

In one embodiment, the metal-containing or metalloid-containing coating layer is a metal-containing or metalloid-containing blocking layer, which is configured to block electromagnetic radiation with a wavelength above 400 nm, or above 450 nm, or above 500 nm. The metal-containing or metalloid-containing coating layer has the added utility of blocking radiation of undesired wavelength to pass through the filter. The metal-containing or metalloid-containing coating layer has the further added utility of functioning as a gas barrier.

In one embodiment, the planarized metal-containing or metalloid-containing coating layer comprises at least two layers of different metal material one upon the other, wherein the one of the layers that faces the environment when the structure is used comprises metal that forms a metal oxide when in contact with air.

Having formed the pre-structure, the same is subjected to a vapor phase densification treatment. In one embodiment, the vapor phase densification treatment is carried out with a solvent in vapor phase at a temperature of 55 - 75 °C, or 60 - 70 °C, for 1 second - 120 seconds, or 15 - 105 seconds, or 20 - 90 seconds, or 30 - 60 seconds. The solvent in vapor phase may be isopropyl alcohol. The vapor phase densification treatment may be conducted by using a solvent in vapor phase, i.e. a vaporized solvent. The formed pre-structure may be placed in a chamber where to a solvent vapor is introduced. This solvent vapor may then condense onto the pre-structure, forming a liquid thin solvent film. The drying effect and surface tension of the solvent film may then pull the structure of the pre-structure together to form a denser and mechanically stronger structure. Densification of the pre-structure has the added utility of coupling or bonding the film of carbon nanostructures and the metal-containing or metalloid-containing coating layer such that they are adhered to each other. The adhesion is remained even in harsh conditions.

After the vapor phase densification treatment, the pre-film of carbon nanostructures and the planarization layer are removed from the pre-structure by a dry etching technique to produce the planarized structure. In one embodiment, the dry etching technique is hydrogen-plasma etching, inert gas plasma etching e.g. using argon or nitrogen plasma, laser ablation, or vacuum annealing. The dry etching technique has the added utility of one being capable to remove the planarization layer as well as the pre-film of carbon nanostructures from the pre-structure without attacking the metal-containing or metalloid-containing coating layer or the film of carbon nanostructures. This may be due to the fact that with the dry etching technique only the exposed surface is etched and thus the etching process will stop once the surface of the metal-containing or metalloid-containing coating layer is reached. The dry etching technique has the added utility of one being able to avoid oxidation that would adversely affect the remaining structure, to take place. E.g. wet etching techniques usually include liquid chemicals containing oxidizing agents that may attack the carbon nanostructure resulting e.g. to disrupted electrical properties of the carbon nanostructures or the unwanted introduction of oxygen functional groups on the surface of the carbon nanostructures.

Thus, as above described, is formed a planarized structure exhibiting a smooth and uniform surface. The roughness of an EUV pellicle, such as average surface roughness value measured as Ra, should be at most 50 nm to meet performance standards for EUV lithography. Surface roughness is critical to minimize scattering of EUV light and to maintain optical and mechanical performance under high thermal and radiative loads.

The planarized structure obtainable by the method as disclosed in the current specification may exhibit, on at least one side thereof, an average surface roughness value Ra of at most 50 nm as determined by using an atomic force microscopy.

The term "average surface roughness" as used herein may be taken to refer to the microscopic roughness of the surface, e.g. of the surface of the planarized metal-containing or metalloid-containing coating layer, measured in nanometers using an atomic force microscopy. This measurement is distinct from the macroscopic flatness of the flexible planarized structure, which pertains to the overall shape and flatness of the planarized structure over a larger scale. The average surface roughness value Ra may be taken as the calculated average between peaks and valleys on a surface area of 10 x 10 µm². A lower Ra value indicates less variation between the peaks and troughs on a surface, resulting in a smoother surface.

The planarized structure obtainable by the method as disclosed in the current specification has the added utility of having properties, such as average surface roughness and percentage transmittance value, enabling its use and proper functioning under extreme ultraviolet light and high vacuum conditions.

In one embodiment, produced is a planarized structure exhibiting, on at least one side thereof, an average surface roughness value Ra of at most 50 nm, or at most 45 nm, or at most 40 nm, or at most 35 nm or at most 30 nm. In one embodiment, produced is a planarized structure exhibiting, on at least one side thereof, an average surface roughness value Rs of 0.1 - 0.5 nm. In one embodiment, produced is a planarized structure exhibiting, on at least one side thereof, an average surface roughness value Rs of 0.1 - 10 nm or 0.5 - 7 nm, or 1 - 4 nm. A profilometer, such as atomic force microscopy (AFM), may be used to determine the Ra and Rs values.

The planarized structure formed may be taken to have two sides, one being formed of the planarized metal-containing or metalloid-containing coating layer and the other being formed of the film of carbon nanostructures. At least one of these sides may exhibit an average surface roughness value Ra of at most 50 nm, at most 45 nm, or at most 40 nm, or at most 35 nm or at most 30 nm. In one embodiment, both sides of the planarized structure exhibits an average surface roughness value Ra of at most 50 nm, at most 45 nm, or at most 40 nm, or at most 35 nm or at most 30 nm. In one embodiment, the planarized structure exhibits, on the side of the planarized metal-containing or metalloid-containing coating layer, an average surface roughness value Ra of at most 50 nm, at most 45 nm, or at most 40 nm, or at most 35 nm or at most 30 nm. In one embodiment, produced is a planarized structure exhibiting, on each side thereof, an average surface roughness value Ra of 0.1 - 10 nm or 0.5 - 7 nm, or 1 - 4 nm.

In one embodiment, produced is a planarized structure exhibiting, on at least one side thereof, an average surface roughness value Ra of at most 1 nm and Rs of at most 10 nm, or at most 5 nm. Such values may be used

In one embodiment, produced is a planarized structure exhibiting, on at least one side thereof, an average surface roughness value Ra of at most 5 nm, or at most 2 nm, and Rs of at most 20 nm, or at most 10 nm.

In one embodiment, produced is a planarized structure exhibiting, on at least one side thereof, an average surface roughness value Ra of at most 0.2 nm, or at most 0.1 nm, and Rs of at most 1 nm, or at most 0.5 nm. In one embodiment, the planarized structure obtainable by the method as disclosed in the current specification exhibits a percentage transmittance value (%T) of 0 - 30 %, or 1 - 20 %, or 2 - 10 %, or 4 - 8 %, when measured at the wavelength range of 380 - 780 nm.

In one embodiment, the planarized structure obtainable by the method as disclosed in the current specification is an optical filter and it exhibits a percentage transmittance value (%T) of 0 - 30 %, or 1 - 20 %, or 2 - 10 %, or 4 - 8 %, when measured at the wavelength range of 380 - 780 nm.

In one embodiment, the planarized structure obtainable by the method as disclosed in the current specification exhibits a percentage transmittance value (%T) of 45 - 95 %, or 50 - 90 %, or 55 - 85 %, when measured at the wavelength range of 13.3 - 13.7 nm. In one embodiment, the planarized structure obtainable by the method as disclosed in the current specification is an EUV pellicle and it exhibits a percentage transmittance value (%T) of 45 - 95 %, or 50 - 90 %, or 55 - 85 %, when measured at the wavelength range of 13.3 - 13.7 nm.

The percentage transmittance value may be measured by a spectroscopic method. The term "percent transmittance value" may also be used instead of "percentage transmittance value".

The planarized structure formed by the method as disclosed in the current specification has the added utility of exhibiting a smooth and uniform surface that is required in many applications. A layer of carbon nanostructures may be a porous film exhibiting pinholes making the surface of the film coarse or rough. The method as disclosed in the current disclosure has the added utility of planarizing the surface of the pre-film of carbon nanostructures such that a smooth and pinhole-free surface is formed affecting the smoothness of the following metal-containing or metalloid-containing coating layer. The smooth surfaces of the planarized structure have the added utility of improving the visible transmittance through the structure.

In one embodiment, the method for producing the planarized structure is a dry method for producing the planarized structures. The term "dry method" may refer to the fact that throughout the production process only vapor phase techniques are used to produce the layers/films and no liquid- or solvent-based techniques are used. In one embodiment, no liquid-based techniques or solvent-based techniques are used in the method. The method being a so-called "dry method" has the added utility of providing such a smooth surface to the formed structure. The vapor phase techniques used in the method has the added utility of enabling accurate thickness control of the different layers as well as enabling the formation of a truly smooth and uniform surface of the separate layers.

Solvent-based processes typically involve wetting and drying steps which often result in cracks and structural disintegrations in the formed layers due to surface tension and capillary action. Such may be avoided with the method as described in the current specification.

The formed planarized structure may be used for different applications. In one embodiment, the planarized structure is an optical filter, a debris filter, a pellicle, a membrane filter, an electron blocking window, or any combination of at least two of these.

Further, using a planarization layer on the pre-film of carbon nanostructures for forming thereon a metal-containing or metalloid-containing coating layer, has the added utility of oxidation taking place between the metal and the carbon nanostructures is being reduced or hindered.

### EXAMPLES

Reference will now be made in detail to the described embodiments, an example of which is illustrated in the accompanying drawing.

The description below discloses some embodiments in such a detail that a person skilled in the art is able to utilize the method based on the disclosure. Not all steps of the embodiments are discussed in detail, as some of the steps may be obvious for the person skilled in the art based on this specification.

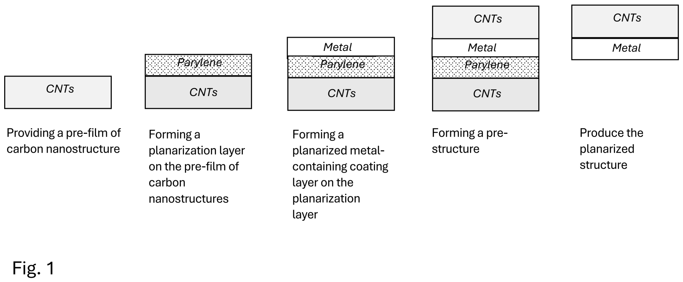

Fig. 1 present one embodiment for producing the planarized structure as disclosed in the current specification.

Firstly is provided a pre-film of carbon nanostructures. The pre-film of carbon nanostructures may be formed by e.g. a gas phase process, wherein carbon nanostructures, such as carbon nanotubes (marked as CNTs in Fig. 1), are synthesized in a gas phase and then deposited or collected on a substrate, such as a porous filter. From the substrate the formed pre-film of carbon nanostructures can be detached and transferred to e.g. a support, such as a frame.

Then, a polymer-based material (marked as parylene in Fig. 1) is formed on the pre-film of carbon nanostructures (CNTs) by a first vapor phase deposition technique to form a planarization layer on the pre-film of carbon nanostructures.

Then, a metal-containing material (marked as metal in Fig. 1) is formed on the planarization layer (parylene) by a second vapor phase deposition technique to form a planarized metal-containing coating layer on the planarization layer.

Then, a film of carbon nanostructures (marked as CNTs) is provided on the planarized metal-containing coating layer (metal) to form a pre-structure.

These steps are followed by subjecting the formed pre-structure to a vapor phase densification treatment, after which the pre-film of carbon nanostructures and the planarization layer are removed from the pre-structure by a dry etching technique to produce the planarized structure. The planarized structure thus is formed of the planarized metal-containing coating layer and the film of carbon nanostructures (CNTs).

### Example 1 - Producing a planarized structure

In this example different planarized structures were produced and tested. The materials used are presented in Table 1.

**Table 1. Materials used for producing the planarized structures**

| | Material |
|---|---|
| Porous collection filter | Mixed cellulose ester |
| Support | Circular frame of steel* |
| Carbon nanostructures | Carbon nanotubes |
| Planarization layer | Parylene N |
| Metal-containing coating layer | Mo |

| | |
|---|---|
| *A circular frame, 21 mm inner diameter, 37 mm outer diameter | |

Firstly, carbon nanotubes were synthesized in an aerosol laminar flow (floating catalyst) reactor using carbon monoxide and ferrocene as a carbon source and a catalyst precursor, respectively. The formed carbon nanotubes were deposited from the gas phase onto a porous collection filter at a total gas flow rate of 60 l/min (gas velocity of max 0.13 m/s) to form a pre-film of carbon nanotubes on the porous collection filter. The temperature of the gas was about 60 °C. The thickness of the formed pre-film of carbon nanotubes was 50 nm, which corresponds to 81%T at 550 nm wavelength.

The formed pre-film of carbon nanotubes was then transferred from the porous collection filter to a rectangular plastic frame that was larger than the final circular frame. Then the same was transferred to the final circular-shaped frame to form a free-standing pre-film of carbon nanotubes attached to the frame. The frame thus had a circular form with an opening in the middle.

Thereafter a polymer-based material was deposited on the pre-film of carbon nanotubes. In this example parylene N was used as the polymer-based material. The planarization layer was formed by using thermal evaporation deposition as follows: Pyrolysis at about 680 °C of a di-p-xylene (dimer) in a vacuum environment which was then deposited on a cooler (i.e. room temperature) substrate inside the deposition chamber while under continuous vacuum. The thickness of the parylene planarization layer was 130 nm.

Then a metal-containing coating layer of Mo was formed on the planarization layer with a second vapor phase deposition technique, in this case sputtering deposition using Ar-plasma (base pressure 1E-5 mbar, operating pressure 1E-3 mbar, deposition rate of about 5 Å/sec, non-heated samples, the sputtering target was precleaned for 1 min prior to deposition to remove native oxide). The thickness of the metal-containing coating layer was 40 nm.

Upon the metal-containing coating layer was then formed a film of carbon nanotubes produced as above described.

The formed pre-structure was then subjected to vapor phase densification treatment by placing the pre-structure into a chamber into which an isopropanol vapor was introduced at a temperature of 66 °C for 60 seconds.

After the vapor phase densification treatment hydrogen-plasma etching (RF power 40 W, hydrogen 20 sccm, base pressure 1 mbar, operating pressure 500 mbar, 40 min) was used to remove the pre-film of carbon nanotubes and the planarization layer from the pre-structure.

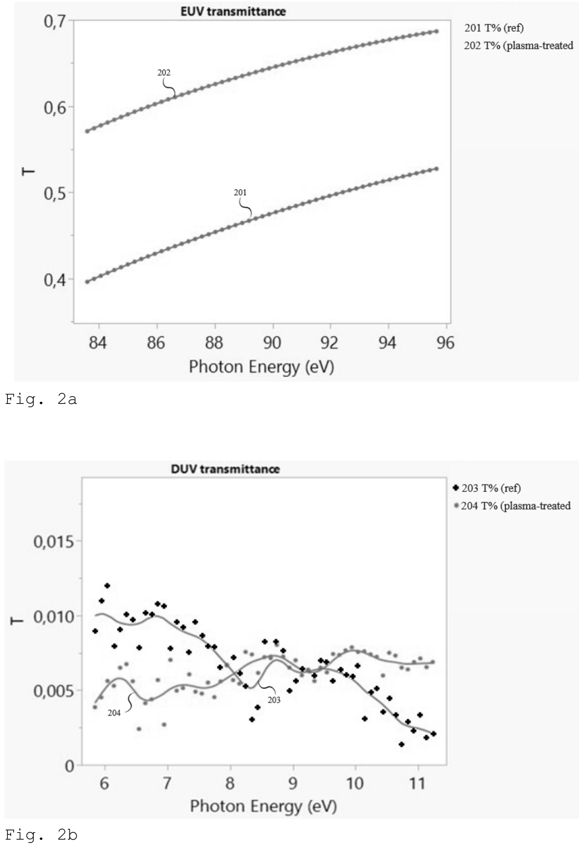

The formed planarized structures were subjected EUV and DUV (deep ultraviolet radiation) measurements by using a particle accelerator (synchrotron). Also the pre-structure was subjected to the same measurements as a reference sample. The results are presented in Figs. 2a ja 2b.

### Example 2 - Testing planarized structures

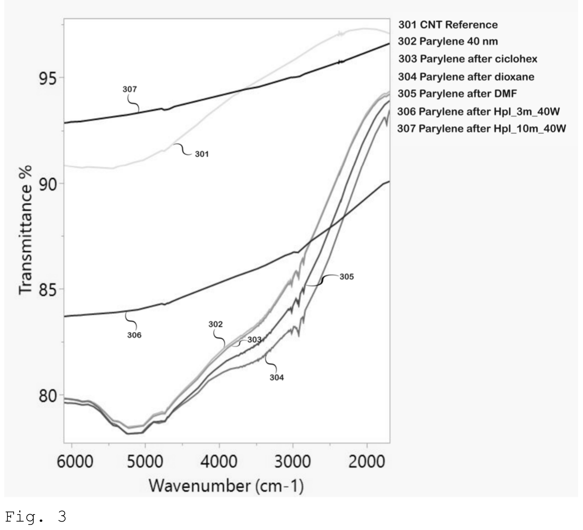

In this example the pre-structures produced as produced in example 1 were subjected to different procedures in order to remove the pre-film of carbon nanotubes and the parylene-planarization layer therefrom. Hydrogen-plasma etching (RF power 40 W, hydrogen 20 sccm, base pressure 1 mbar, operating pressure 500 mbar, 40 min) was used and compared to using the following solvents: cyclohexane, dioxane, and dimethylformamide. The comparative samples were kept in these solvents at room temperature for 30 minutes. The test results are presented in Fig. 3. From the results one may see that the solvents tested did not remove the parylene-planarization layer.

### Example 3 - Testing planarized structures

In this example the planarized structures produced following the description in example 1 were tested and compared to samples, wherein a metal-containing coating layer was directly formed on a film of carbon nanotubes without using the planarization layer. A Mo-containing coating layer was formed as the metal-containing coating layer in both the example sample and the comparative sample.

The formed samples were subjected EUV and DUV (deep ultraviolet radiation) measurements by using a particle accelerator (synchrotron).

The results indicated that when producing a planarized structure, i.e. when using a planarization layer of a polymer-based material on which the Mo-containing coating layer is formed, the visible transmittance was about 2 %, whereas forming the same material directly on a film of carbon nanostructures without using a planarization layer of a polymer-based material, the visible transmittance was about 10 %.

It was concluded that the difference in the visible transmittance was due to pinholes in the porous film of carbon nanotubes, contrary to the situation where the Mo-containing coating layer was formed on a planarization layer, which makes the surface continuous and ideally pinhole-free.

Further, it was also concluded that when forming the Mo-containing coating layer directly on the porous film of carbon nanotubes, oxidation takes place due to the disordered morphology which translates into increased chemical reactivity.

It is obvious to a person skilled in the art that with the advancement of technology, the basic idea may be implemented in various ways. The embodiments are thus not limited to the examples described above; instead they may vary within the scope of the claims.

The embodiments described hereinbefore may be used in any combination with each other. Several of the embodiments may be combined together to form a further embodiment. A method or a use, as disclosed herein, may comprise at least one of the embodiments described hereinbefore. It will be understood that the benefits and advantages described above may relate to one embodiment or may relate to several embodiments. The embodiments are not limited to those that solve any or all of the stated problems or those that have any or all of the stated benefits and advantages. It will further be understood that reference to 'an' item refers to one or more of those items. The term "comprising" is used in this specification to mean including the feature(s) or act(s) followed thereafter, without excluding the presence of one or more additional features or acts.

## Claims

1. A method for producing a planarized structure comprising a film of carbon nanostructures on a metal-containing or metalloid-containing coating layer, wherein the method comprises:
- providing a pre-film of carbon nanostructures,
- forming a polymer-based material on the pre-film of carbon nanostructures by a first vapor phase deposition technique to form a planarization layer on the pre-film of carbon nanostructures,
- forming a metal-containing or metalloid-containing material on the planarization layer by a second vapor phase deposition technique to form a planarized metal-containing or metalloid-containing coating layer on the planarization layer,
- providing a film of carbon nanostructures on the planarized metal-containing or metalloid-containing coating layer to form a pre-structure,
- subjecting the formed pre-structure to a vapor phase densification treatment, and
- removing the pre-film of carbon nanostructures and the planarization layer from the pre-structure by a dry etching technique to produce the planarized structure.

2. The method of claim 1, wherein the pre-film of carbon nanostructures is a free-standing pre-film of carbon nanostructures or a mesh-supported pre-film of carbon nanostructures.

3. The method of any one of the preceding claims, wherein the polymer-based material is an oxygen-free polymer material.

4. The method of any one of the preceding claims, wherein the first vapor phase deposition technique is thermal evaporation deposition, molecular layer deposition (MLD), or chemical vapor deposition (CVD) .

5. The method of any one of the preceding claims, wherein the method comprises forming a planarization layer having a thickness of 1 - 200 nm, or 5 - 180 nm, or 10 - 150 nm, or 20 - 100 nm, or 30 - 80 nm, or 40 - 60 nm.

6. The method of any one of the preceding claims, wherein the second vapor phase deposition technique is selected from sputtering deposition, electron-beam physical vapor deposition, thermal evaporation deposition, cathodic arc deposition, pulsed laser deposition, or ion beam-assisted deposition.

7. The method of any one of the preceding claims, wherein the metal-containing material is a material based on aluminium, zirconium, tungsten, molybdenum, titanium, yttrium, metal silicide, ruthenium, beryllium, gold, palladium, or niobium.

8. The method of any one of the preceding claims, wherein the metalloid-containing material is a material based on silicon or boron.

9. The method of any one of the preceding claims, wherein the dry etching technique is hydrogen-plasma etching, inert gas plasma etching, laser ablation, or vacuum annealing.

10. The method of any one of the preceding claims, wherein the planarized metal-containing or metalloid-containing coating layer comprises at least two layers of different metal material one upon the other, wherein the one of the layers that faces the environment when the structure is used comprises metal that forms a metal oxide when in contact with air.

11. The method of any one of the preceding claims, wherein the vapor phase densification treatment is carried out with a solvent in vapor phase at a temperature of 55 - 75 °C, or 60 - 70 °C, for 15 - 120 seconds, or 20 - 90 seconds, or 30 - 60 seconds.

12. The method of any one of the preceding claims, wherein the planarized structure exhibits a percentage transmittance value (%T) of 0 - 30 %, or 1 - 20 %, or 2 - 10 %, or 4 - 8 %, when measured at the wavelength range of 380 - 780 nm and/or
wherein the planarized structure exhibits a percentage transmittance value of (%T) 45 - 95 %, or 50 - 90 %, or 55 - 85 %, when measured at the wavelength range of 13.3 - 13.7 nm.

13. The method of any one of the preceding claims, wherein the planarized structure is an optical filter, a debris filter, a pellicle, a membrane filter, an electron blocking window, or any combination of at least two of these.

14. Use of a planarized structure obtainable by the method of any one of claims 1 - 13 as an optical filter, a debris filter, a pellicle, a membrane filter, an electron blocking window, or any combination of at least two of these.

15. The use of claim 14, wherein the planarized structure is used as an extreme ultraviolet lithography pellicle.
